Europäisches Patentamt

European Patent Office

Office européen des brevets

(19)

(11) Veröffentlichungsnummer : **0 034 283**
**B1**

(12) **EUROPÄISCHE PATENTSCHRIFT**

(45) Veröffentlichungstag der Patentschrift :
15.05.85

(21) Anmeldenummer : 81100641.0

(22) Anmeldetag : 29.01.81

(51) Int. Cl.⁴ : **C 21 D 9/00**, C 22 F 1/00,
B 22 D 27/04, C 30 B 13/00,
C 30 B 13/32, C 30 B 21/00

(54) **Verfahren und Vorrichtung zum zonenweisen Erwärmen bzw. Abkühlen länglicher Behandlungskörper.**

(30) Priorität : 31.01.80 DE 3003429

(43) Veröffentlichungstag der Anmeldung :
26.08.81 Patentblatt 81/34

(45) Bekanntmachung des Hinweises auf die Patenterteilung : 15.05.85 Patentblatt 85/20

(84) Benannte Vertragsstaaten :
BE CH FR GB LI NL

(56) Entgegenhaltungen :
DD-A-    139 801
GB-A- 1 269 833
US-A- 3 124 452
US-A- 3 498 851
Die Akte enthält technische Angaben, die nach dem Eingang der Anmeldung eingereicht wurden und die nicht in dieser Patentschrift enthalten sind.

(73) Patentinhaber : Kernforschungsanlage Jülich Gesellschaft mit beschränkter Haftung
Postfach 1913
D-5170 Jülich (DE)

(72) Erfinder : Welter, Jean-Marie, Dr.
Wirichsbongardstrasse 43
D-5100 Aachen (DE)

EP 0 034 283 B1

**Beschreibung**

Die Erfindung bezieht sich auf ein Verfahren zur kontinuierlichen, zonenweisen Erwärmung oder Abkühlung einer Serie von Behandlungskörpern, die in paralleler Anordnung aufeinander folgend einen Ofen mit zumindest einer länglichen ggf. gekrümmten Heiz- bzw. Kühlzone derart durchlaufen, daß ihre Bewegungsrichtung eine spitzen Winkel mit der oder den Heiz- oder Kühlzone(n) bildet, sowie auf eine Vorrichtung zur Durchführung des Verfahrens.

Die zonenweise Erwärmung oder Abkühlung länglicher Körper spielt eine wichtige Rolle bei der Herstellung von gerichtet erstarrten Formkörpern, wie z. B. Hochleistungsturbinenschaufeln und Dauermagneten, von zonengeschmolzenen, besonders sauberen ein- und polykristallinen Körpern, die z. B. aus Silizium bestehen, sowie von vergüteten Produkten durch zonenweises Tempern.

Sowohl die gerichtete Erstarrung als auch das Zonenschmelzen sind seit langem geübte Techniken. Dabei werden die üblicherweise länglichen Behandlungskörper und senkrecht zu deren Längsachse liegende Heiz- oder Kühlzonen relativ zueinander bewegt.

Die bekannten Vorrichtungen zur Durchführung dieser Verfahren werden mit Einzelkörpen chargenweise betrieben. Dabei müssen oft erhebliche Umrüstzeiten für die Einführung neuer Behandlungskörper in Kauf genommen werden. Wegen des geringen Durchsatzes wird daher eine Vielzahl von Einzelanlagen benötigt, um größere Materialmengen zu produzieren.

In der GB-PS 1 269 833 wird allerdings bereits eine Anlage zur Erzeugung von Gegenständen mit gerichteter Kristallstruktur beschrieben, bei der eine Serie von länglichen Tiegeln mit Metallschmelze auf einem Drehtisch längs einer Kreisbahn durch einen über dem Tisch montierten Ofen bewegt werden, dessen Heizelemente keilförmig angeordnet sind, wobei die Länge der von oben in den Ofenraum hineinragenden Heizelemente vom Eingang des Ofens bis zum Ausgang kontinuierlich abnimmt.

Bei dieser Anordnung mit geneigt zur Horizontalen verlaufenden Isothermen wandert die Erstarrungsfront mit Fortschritt des Tiegels im Ofen durch die im Tiegel enthaltene Metallschmelze von unten nach oben unter Ausbildung einer gerichteten Kristallisation. In der Praxis treten nun jedoch an der Erstarrungsfront innerhalb der Schmelze Kräfte auf, die zu einer Störung der einwandfreien Kristallisation Anlaß geben.

Ziel der Erfindung ist daher die Ausgestaltung einer solchen Serienproduktion mit einer zur Bewegungsbahn der Behandlungskörper geneigten Wärmefront des Ofens, bei der ein möglichst störungsfreies Kristallwachstum erzielt werden kann.

Zu diesem Zweck ist das erfindungsgemäße Verfahren der eingangs genannten Art dadurch gekennzeichnet, daß die Behandlungskörper auf einer gegen die Horizontale geneigten Bahn mit konstanter Vertikalausrichtung durch zumindest eine horizontale Heiz- oder Kühlzone bewegt werden.

Besonderheiten der Erfindung gehen aus den Patentansprüchen hervor.

Realisierungsmöglichkeiten für Anordnungen zur Durchführung des Verfahrens werden nachfolgend anhand von Beispielen beschrieben. Die Beschreibung bezieht sich auf die angefügten Zeichnungen ; es zeigen im Schema :

Figur 1 und 2 eine Vorrichtung, die insbesondere zur Erzeugung gerichtet erstarrter Körper geeignet ist, und

Figur 3 und 4 eine weitere Vorrichtung zur Durchführung eines Zonenschmelzverfahrens.

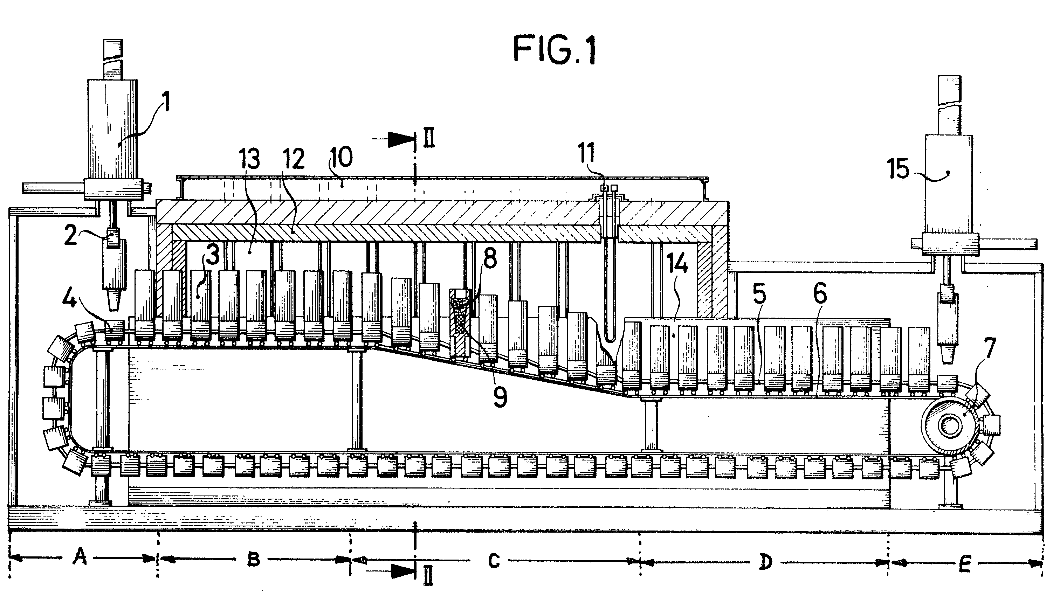

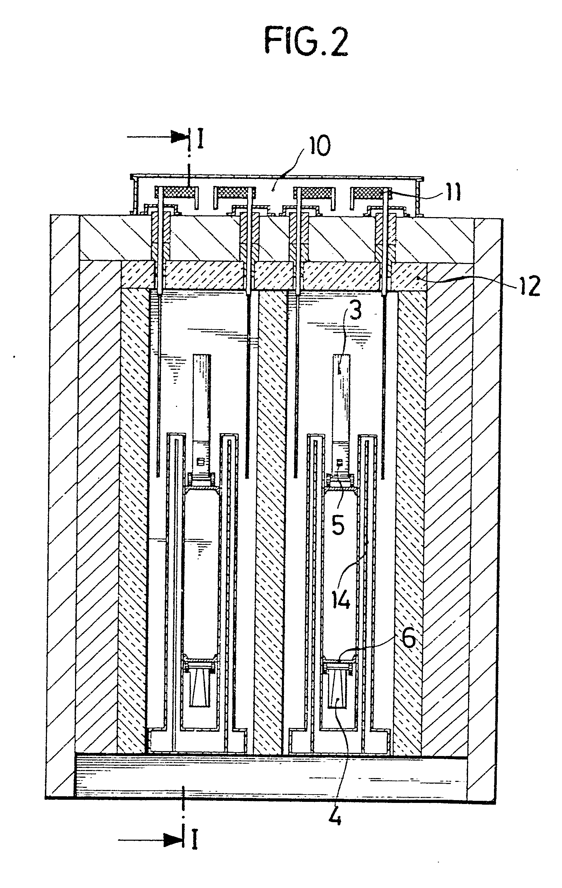

Die in Fig. 1 und 2 skizzierte Anlage ist ausgelegt als

— Tandemofen, um verschiedene Hilfsaggregate und seitliche Wärmeverluste einzusparen ;

— Vakuumofen, um die Kontamination der Schmelze durch die Luftkomponenten zu vermeiden und um Wärmeverluste über Konvektion zu unterbinden. Eine Druckerniedrigung in den Bereich von 0.1 mbar ist ausreichend und wird mit Wälzkolbenpumpen bewerkstelligt.

Die Anlage ist in die fünf Bereiche A bis E unterteilt. Der eigentliche Durchlaufofen besteht aus den drei Bereichen B, C und D.

Im Ausführungsbeispiel wird der obere Teil 13 der Ofenkammer elektrisch beheizt. Dazu werden Hochtemperatur-Widerstandselemente 11 durch die Ofendecke 12 geführt und im Schaltkasten 10 elektrisch miteinander verbunden. Die Ofenwand besteht aus hochtemperaturbeständigen Keramiksteinen. Der untere Bereich wird mit einem Paar wassergekühlter Strahlungsschilde 14 gegen die Hitzeeinwirkung abgeschirmt. Durch das Hochziehen dieser Kühlschilde in den oberen Teil der Ofenkammer wird ein kalter Schacht hergestellt mit einem schnellen Übergang hohe/tiefe Temperaturen. Dies bewirkt einen sehr effektiven vertikalen Temperaturgradienten, wie er zum Beispiel bei der Herstellung von eutektischen Kristallen benötigt wird. Dabei braucht der obere Teil der Ofenkammer nur auf konstanter Temperatur gehalten zu werden.

— In der Einbaustrecke A wird der Tiegel 3 mit dem Füllgut mit einem Greifsytem 2 von einem externen Stapelband durch die Vakuumschleuse 1 in die Anlage transferiert und in den Tiegelhalter 4 eingesetzt. Die Tiegelhalter laufen auf den Leitschienen 6 und bilden mit Hilfe der Kettenglieder 5 ein Endlosförderband. Das Leitrad 7 bewegt mit vorwählbarer Geschwindigkeit das Band weiter. Die Taktzeit des Transfersystems ergibt sich aus dem Tiegelhalterabstand und aus der Fördergeschwindigkeit.

— In der Aufschmelzstrecke B bewegt sich der Tiegel oberhalb des kalten Schachts und wird aufgeheizt. Die Tiegelfüllung wird aufgeschmolzen und auf die gewünschte Endtemperatur gebracht. Dies wird dadurch erreicht, daß dieser Ofenbereich mit einem horizontalen Temperaturgradienten ausgestattet ist.

— In der Erstarrungsstrecke C wird durch eine Schrägbewegung des Förderbandes der Tiegel in den kalten Schacht heruntergefahren, so daß nach und nach die Schmelze 8 zum Kristall 9 erstarrt. Das Führungssystem des Bandes ist ausgelegt, um die Tiegelhalter und insofern die Phasengrenze fest/flüssig immer horizontal zu halten. Die Erstarrungsgeschwindigkeit ist gegeben durch den Neigungswinkel der Führungsschienen und durch die Fördergeschwindigkeit. Durch eine lokale Änderung des Neigungswinkels kann die Erstarrungsgeschwindigkeit beeinflußt werden. Dies ist von Vorteil bei komplizierten Formkörpern, wo verschiedene Bereiche unterschiedlich schnell erstarren müssen.

— In der Abkühlstrecke D befindet sich der Tiegel gänzlich im kalten Schacht und der Kristall kühlt langsam ab, um das Auftreten von mechanischen Spannungen zu unterbinden.

— In der Ausbaustrecke E findet dieselbe Sequenz von Arbeitsschritten statt wie in der Einbaustrecke, nur in umgekehrter Reihenfolge, um den Tiegel durch die Ausbauschleuse 15 auf ein Stapelband zu transferieren.

Zusatzeinrichtungen wie externe Stapelbänder, Antriebsmotoren, Vakuumaggregate, Meßeinrichtungen für Temperatur und Vakuum, sind nicht gezeigt.

Die skizzierte Anlage ist wie folgt dimensioniert :

| | |
|---|---|
| Länge der Gesamtanlage | 1 080 cm |
| Länge der beheizten Strecke | 550 cm |
| Volumen der beheizten Strecke (pro Schacht) | $0,6 \cdot 10^6$ cm³ |
| Ofentemperatur | ca. 1 500 °C |
| Benötigte Heizleistung (pro Schacht) | ca. 70 kW |
| Zahl der Heizelemente (pro Schacht) | ca. 20 Stück |
| Länge der Erstarrungsstrecke | 300 cm |
| Neigung des Förderbandes | 10 % |
| Fördergeschwindigkeit | 50 cm/h |
| Erstarrungsgeschwindigkeit | 5 cm/h |
| Tiegelabmessungen (H x B x D) | 50 × 20 × 10 cm³ |
| Höhe der Schmelze | ca. 30 cm |

Die Anlage kann vollautomatisch arbeiten. Während eines 24-Stunden-Betriebes werden ca. 50 Formkörper pro Schacht, also insgesamt für die Anlage ca. 100 Körper, hergestellt.

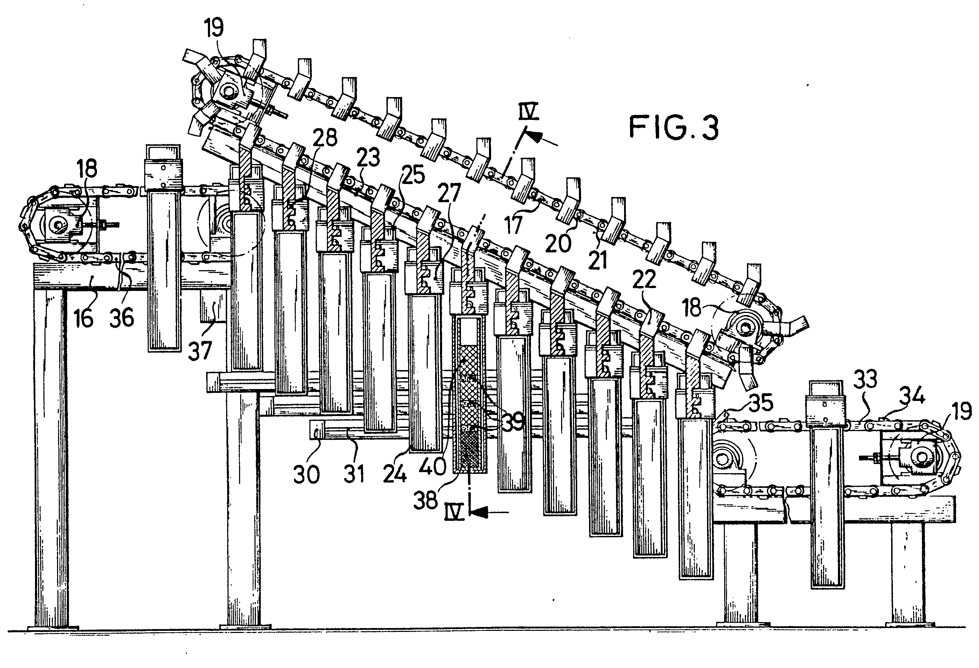

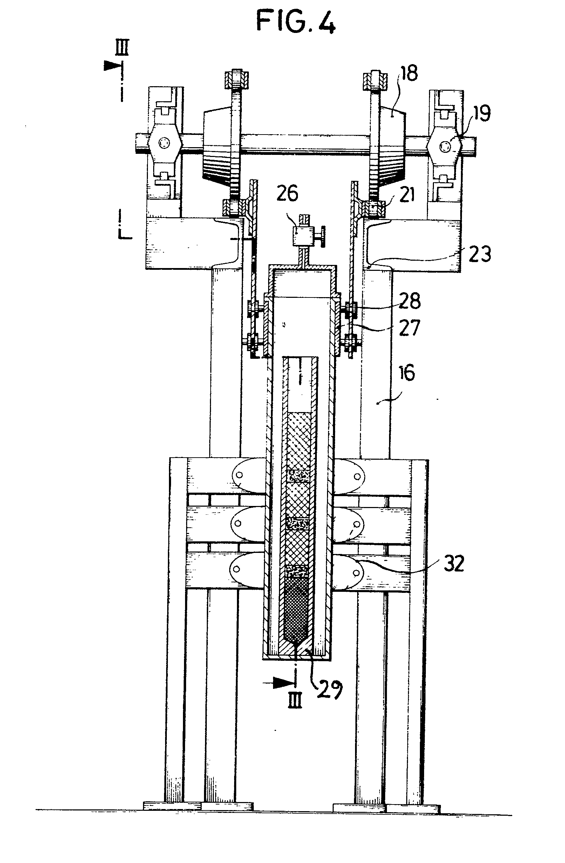

Die in Fig. 3 und 4 skizzierte Anlage zum Zonenschmelzen von länglichen Behandlungskörpern besitzt die folgenden konstruktiven und verfahrenstechnischen Merkmale :

— Ein Hauptelement ist das gegen die Horizontale geneigte, umlaufende Endlosband 17, an dessen Kettengliedern 20 die Aufhängungshaken 22 für die Tiegelbehälter 24 befestigt sind. Um einen gleichförmigen Lauf zu erzielen, wird wenigstens ein Leitrad 18 mit der Vorrichtung 19 gespannt. Weiterhin laufen die Kettenrollen 21 auf der Leitschiene 23.

Der Tiegelbehälter 24 besteht in diesem Ausführungsbeispiel aus einem einseitig geschlossenen Quarzglasrohr. Nach Füllung des Tiegels 29 mit dem zu reinigenden Gut 38 wird es in den Behälter eingebaut. Dieser wird mit dem Deckel 25 hermetisch abgeschlossen und über das Ventil 26 evakuiert und eventuell mit einer geeigneten Gasmischung gefüllt. Für die weitere maschinelle Handhabung des Tiegelbehälters ist eine zwei Nockenpaare 28 besitzende Manschette 27 vorgesehen.

— Nach der Vorbereitung einer Serie von Tiegelbehältern werden diese in Wartestellung auf das Förderband 33 montiert, durch die Reiter 34 zum Ofenteil transportiert und mit dem Schwenkarm 35 in die Aufhängungshaken 22 eingeklinkt. Da hier angenommen wurde, daß die Dichte der Schmelze des zu reinigenden Materials größer ist als die des Festkörpers, wird der Tiegel so in den Ofenteil eingefahren, daß zuerst der obere, freie Teil 40 des Materials aufschmilzt und wieder erstarrt.

— In dieser Anlage werden drei Schmelzzonen 39 mit den Linienstrahlern 30 aufgeschmolzen. Die von den Wolframwendeln 31 emittierte Strahlung wird mit den Ellipsoidspiegeln 32 auf die Tiegelwand fokussiert. Entsprechend dem Neigungswinkel des Förderbandes und dem Abstand der Wendeln sind die Strahlen versetzt montiert. Da die Wärme nur von zwei gegenüberliegenden Seiten in die Tiegel eingestrahlt wird, ist ein großes Verhältnis Breite/Tiefe günstig, um ein gleichmäßiges Aufheizen zu gewähren. Um die Strahlungsverluste klein zu halten, ist es ebenfalls günstig, die Tiegel möglichst dicht aufeinander folgen zu lassen. Nach dem Durchlaufen der Ofenzone klinkt der pneumatische Kolben 37 die Tiegelbehälter aus und hebt sie auf das Förderband 36 über. Hier kühlen sie ab und bleiben bis zur weiteren Behandlung gelagert.

— Die drei Förderbänder 17, 33 und 36 und die drei Strahlerpaare 30 sind in dem Rahmen 16 montiert. Die Antriebsaggregate der Bänder und die Taktsteuerung der Ein- und Ausklinkelemente sind nicht gezeigt.

Der Neigungswinkel des zentralen Förderbandes der dargestellten Anlage ist 25°. Bei einer typischen Umkristallisationsgeschwindigkeit von 1 mm/min braucht der Tiegelbehälter ungefähr 600 min, um die Ofenzone zu durchlaufen. Bei einem Tiegelabstand von 137,5 mm verläßt ungefähr alle 64 min ein Tiegelbehälter den Ofenbereich. Bei dem bekannten diskontinuierlichen Verfahren verbleibt bei derselben Umkristallisationsgeschwindigkeit ein Tiegel wenigstens 800 min in der Anlage. Durch die neuartige Anlage wird also eine dreizehnfache Kapazitätssteigerung erreicht.

Als Änderungsmöglichkeiten der beschriebenen Anlage sind zum Beispiel zu nennen :

— Umkehr der Aufschmelzrichtung, wenn die Schmelze eine höhere Dichte als der Festkörper besitzt ;

— Aufschmelzen mit Hochfrequenzenergie unter Benutzung einer länglichen Induktorspule ;

— Horizontales Aufhängen des Tiegelbehälters zwischen zwei schräg laufenden Förderbändern, um mit einer vertikalen Ofenanordnung die Schmelzzonen waagerecht in einem offenen Bootstiegel zu bewegen.

## Patentansprüche

1. Verfahren zur kontinuierlichen, zonenweisen Erwärmung oder Abkühlung einer Serie von Behandlungskörpern, die in paralleler Anordnung aufeinander folgend einen Ofen mit zumindest einer länglichen ggf. gekrümmten Heiz- bzw. Kühlzone derart durchlaufen, daß ihre Bewegungsrichtung einen spitzen Winkel mit der oder den Heiz- oder Kühlzone(n) bildet, dadurch gekennzeichnet, daß die Behandlungskörper auf einer gegen die Horizontale geneigten Bahn mit konstanter Vertikalausrichtung durch zumindest eine horizontale Heiz- oder Kühlzone bewegt werden.

2. Verfahren nach Anspruch 1, dadurch gekennzeichnet, daß man die Behandlungskörper durch mehrere längliche, parallel zueinander angeordnete horizontale Heiz- bzw. Kühlzonen bewegt.

3. Verfahren nach Anspruch 1 oder 2, dadurch gekennzeichnet, daß man die Aufheiz- oder Abkühlgeschwindigkeit durch Änderung des Neigungswinkels der geneigten Bahn gegen die Horizontale variiert.

4. Verfahren nach einem der vorangehenden Ansprüche, dadurch gekennzeichnet, daß man die Aufheiz- oder Abkühlgeschwindigkeit durch Änderung der Durchlaufgeschwindigkeit der Behandlungskörper entlang der geneigten Bahn variiert.

5. Verfahren nach einem der vorangehenden Ansprüche zum zonenweisen Aufschmelzen von länglichen Behandlungskörpern, dadurch gekennzeichnet, daß man die Behandlungskörper an einem in der senkrechten Heizzonenhauptebene liegenden, gegen die Horizontale geneigten Transportband hängend oder stehend auf einem solchen Transportband oder eingehängt zwischen zwei Transportbändern bewegt.

6. Verfahren nach einem der Ansprüche 1 bis 4 zur Herstellung von Formkörpern durch gerichtetes Erstarren von in Formtiegeln enthaltenen Schmelzen, dadurch gekennzeichnet, daß man die Tiegel längs einer zur Horizontale geneigten Bahn durch eine längliche Ofenzone mit vertikalem Temperaturanstieg oder -gefälle schickt, deren Extremaltemperaturen beiderseits der Schmelztemperatur der Formkörper liegen.

7. Verfahren nach Anspruch 6, dadurch gekennzeichnet, daß der Temperaturanstieg oder das Temperaturgefälle im Bereich der Behandlungskörper durch Zusammenwirken der Heizelemente des Ofens und von Wärmeabschirmschilden erzeugt wird.

8. Verfahren nach Anspruch 7, dadurch gekennzeichnet, daß das Transportband durch die Wärmeabschirmschilde läuft.

9. Vorrichtung zur kontinuierlichen, zonenweisen Erwärmung oder Abkühlung einer Serie von Behandlungskörpern, die in paralleler Anordnung aufeinander folgend einen Ofen mit zumindest einer länglichen ggf. gekrümmten Heiz- bzw. Kühlzone derart durchlaufen, daß ihre Bewegungsrichtung einen spitzen Winkel mit der oder den Heiz- oder Kühlzone(n) bildet, gekennzeichnet durch zumindest eine horizontale längliche Heizzone und ein in der durch die Heizzonenlängsrichtung gehenden Vertikalebene liegendes, gegen die Horizontale geneigtes Transportband (4 bis 6 bzw. 17).

10. Vorrichtung nach Anspruch 9, dadurch gekennzeichnet, daß das Transportband (17) oberhalb der Heizzone angeordnet ist und Halteelemente (22) zum Einhängen von Behandlungskörpern aufweist.

11. Vorrichtung nach Anspruch 9, gekennzeichnet durch ein unterhalb der Heizzone angeordnetes Transportband (4-6) mit Tiegelaufnahmeplätzen (4), die an den Drehpunkten des Gliederbandes derart montiert sind, daß sie zu sich selbst parallel bleiben.

12. Vorrichtung nach Anspruch 9, dadurch gekennzeichnet, daß zwei Transportbänder beiderseits der Heizzone angeordnet sind mit Halteelementen zum Einspannen der Behandlungskörper an deren beiden Enden, so daß sie zu sich selbst parallel bleiben.

13. Vorrichtung nach einem der Ansprüche 10 bis 12, dadurch gekennzeichnet, daß die Transportbandrollen (21) auf Schienen (23) laufen.

14. Vorrichtung nach einem der Ansprüche 9 bis 12, gekennzeichnet durch Linienstrahler (31) als Heizeinrichtung.

## Claims

1. Process for the continuous zonal heating or cooling of a series of workpieces which pass,

4

following one another in parallel arrangement, through a furnace having at least one elongated and possibly curved heating or cooling zone in such a manner that their direction of movement forms an acute angle with the heating or cooling zone or zones, characterised in that the workpieces are moved with a constant vertical alignment through at least one horizontal heating or cooling zone on a path of travel which is inclined relatively to the horizontal.

2. Process according to claim 1, characterised in that the workpieces are moved through a plurality of elongated horizontal heating or cooling zones which are arranged parallel to one another.

3. Process according to claim 1 or 2, characterised in that the heating or cooling speed is varied by varying the angle of inclination of the inclined path of travel relatively to the horizontal.

4. Process according to one of the preceding claims, characterised in that the heating or cooling speed is varied by varying the speed at which the workpieces pass along the inclined path of travel.

5. Process according to one of the preceding claims for the zonal melting of elongated workpieces, characterised in that the workpieces are moved on a conveyor belt which is inclined relatively to the horizontal and is situated in the vertical main heating zone plane, being suspended from or standing on such a conveyor belt or being suspended between two conveyor belts.

6. Process according to one of claims 1 to 4 for the production of shaped articles by controlled solidification of melts contained in mould crucibles, characterised in that the crucibles are passed along a path inclined relatively to the horizontal through an elongated furnace zone with a vertical temperature rise or drop whose extreme temperatures are at either side of the melting temperature of the shaped articles.

7. Process according to claim 6, characterised in that the temperature rise or the temperature drop is produced in the region of the workpieces by co-operation of heating elements of the furnace and heat barrier shields.

8. Process according to claim 7, characterised in that the conveyor belt runs through the heat barrier shields.

9. Apparatus for the continuous zonal heating or cooling of a series of workpieces which pass, following one another in parallel arrangement, through a furnace having at least one elongated and possibly curved heating or cooling zone in such a manner that their direction of movement forms an acute angle with the heating or cooling zone or zones, characterised by at least one horizontal elongated heating zone and by a conveyor belt (4 to 6 or 17) which is inclined relatively to the horizontal and which is situated in the vertical plane extending through the longitudinal direction of the heating zone.

10. Apparatus according to claim 9, characterised in that the conveyor belt (17) is arranged above the heating zone and comprises holding elements (22) for suspension of workpieces.

11. Apparatus according to claim 9, characterised by a conveyor belt (4-6) which is arranged below the heating zone, having crucible reception means (4) which are so mounted at the pivot points of the link conveyor belt that they remain parallel to one another.

12. Apparatus according to claim 9, characterised in that two conveyor belts are arranged at the two sides of the heating zone, with holding elements for securing workpieces at the two ends thereof, so that they remain parallel to each other.

13. Apparatus according to one of claims 10 to 12, characterised in that the conveyor belt rollers (21) run on rails (23).

14. Apparatus according to one of claims 9 to 12, characterised by line radiators (31) as heating means.

## Revendications

1. Procédé de chauffage ou de refroidissement continu par zones progressives d'une série de corps à traiter, qui passent successivement, suivant une disposition parallèle, dans un four ayant au moins une zone de chauffage ou de refroidissement oblongue et, le cas échéant, incurvée, de manière à ce que leur direction de déplacement fasse un angle aigu avec la zone de chauffage ou de refroidissement, ou avec les zones de chauffage ou de refroidissement, caractérisé en ce qu'il consiste à déplacer les corps à traiter dans au moins une zone horizontale de chauffage ou de refroidissement, suivant une trajectoire inclinée sur l'horizontale, tout en leur conservant une position verticale.

2. Procédé suivant la revendication 1, caractérisé en ce qu'il consiste à déplacer les corps à traiter dans plusieurs zones horizontales oblongées de chauffage ou de refroidissement qui sont disposées parallèlement les unes aux autres.

3. Procédé suivant la revendication 1 ou 2, caractérisé en ce qu'il consiste à modifier la vitesse de chauffage ou de refroidissement en faisant varier l'angle d'inclinaison de la trajectoire inclinée, par rapport à l'horizontale.

4. Procédé suivant l'une des revendications précédentes, caractérisé en ce qu'il consiste à modifier la vitesse de chauffage ou de refroidissement en faisant varier la vitesse de passage des corps à traiter le long de la trajectoire inclinée.

5. Procédé suivant l'une des revendications précédentes pour la fusion par zone de corps oblongs à traiter, caractérisé en ce qu'il consiste à déplacer les corps à traiter sur une bande transporteuse inclinée sur l'horizontale et se trouvant dans le plan principal vertical de la zone de chauffage, en les suspendant ou en les plaçant sur une telle bande transporteuse, ou en les suspendant entre deux bandes transporteuses.

6. Procédé suivant l'une des revendications 1 à 4 pour la fabrication de corps moulés par solidification dirigée de masses fondues contenues dans des creusets de moulage, caractérisé en ce qu'il consiste à faire passer les creusets le long d'une trajectoire inclinée sur l'horizontale, dans une zone oblongue de four, avec accroissement ou abaissement vertical de la température et dont les températures extrêmes se situent de part et d'autre du point de fusion du corps moulé.

7. Procédé suivant la revendication 6, caractérisé en ce qu'il consiste à produire l'accroissement ou l'abaissement de la température dans la région du corps à traiter en faisant coopérer les éléments de chauffage du four et des boucliers de protection vis-à-vis de la chaleur.

8. Procédé suivant la revendication 7, caractérisé en ce qu'il consiste à faire passer la bande transporteuse entre les boucliers de protection contre la chaleur.

9. Installation de chauffage ou de refroidissement continu par zones progressives d'une série de corps à traiter qui passent, successivement en position parallèle, dans un four ayant au moins une zone de chauffage ou de refroidissement oblongue et, le cas échéant, incurvée, de manière à ce que leur direction de déplacement fasse un angle aigu avec la zone de chauffage ou de refroidissement, ou avec les zones de chauffage ou de refroidissement, caractérisée par au moins une zone de chauffage horizontale par oblongue par une bande transporteuse (4 à 6 et 17) inclinée par rapport à l'horizontale et se trouvant dans le plan vertical passant par la direction longitudinale de la zone de chauffage.

10. Installation suivant la revendication 9, caractérisée en ce que la bande transporteuse (17) est disposée au-dessus de la zone de chauffage et présente des éléments de support (22) pour suspendre des corps à traiter.

11. Installation suivant la revendication 9, caractérisée par une bande transporteuse (4 à 6) disposée en-dessous de la zone de chauffage et ayant des emplacements de réception de creusets (4), qui sont montés sur les points d'articulation de la bande transporteuse à maillons, de manière à rester sensiblement parallèles à eux-mêmes.

12. Installation suivant la revendication 9, caractérisée en ce que deux bandes transporteuses sont disposées de part et d'autre de la zone de chauffage et ont des éléments de maintien pour bloquer les corps à traiter à leurs deux extrémités, de sorte qu'ils restent parallèles à eux-mêmes.

13. Installation suivant l'une des revendications 10 à 12, caractérisée en ce que les galets (21) de la bande transporteuse passent sur des rails (23).

14. Installation suivant l'une des revendications 9 à 12, caractérisée par une source linéaire de rayonnement (31) servant de dispositif de chauffage.

# FIG.1

# FIG.2

FIG. 3

# FIG. 4